# EUROPEAN PATENT SPECIFICATION

(11) **EP 2 700 739 B1**
(45) Date of publication and mention of the grant of the patent: **28.12.2016**
(21) Application number: 12774011.6
(22) Date of filing: 20.04.2012
(51) Int. Cl.: C30B 29/36, C23C 16/42, C30B 25/20, H01L 21/205

(54) **PROCESS FOR PRODUCING AN EPITAXIAL SILICON CARBIDE SINGLE-CRYSTAL SUBSTRATE**
VERFAHREN ZUR HERSTELLUNG EINES EPITAXIALEN SILICIUMCARBIDEINKRISTALLSUBSTRATS
PROCÉDÉ DE PRODUCTION D'UN SUBSTRAT MONOCRISTALLIN ÉPITAXIAL DE CARBURE DE SILICIUM

(30) Priority: 21.04.2011 JP 2011095057
(43) Date of publication of application: 26.02.2014
(73) Proprietor: Nippon Steel & Sumitomo Metal Corporation, Tokyo 100-8071 (JP)
(72) Inventor: AIGO, Takashi, Tokyo 100-8071 (JP); TSUGE, Hiroshi, Tokyo 100-8071 (JP); KATSUNO, Masakazu, Tokyo 100-8071 (JP); FUJIMOTO, Tatsuo, Tokyo 100-8071 (JP); YASHIRO, Hirokatsu, Tokyo 100-8071 (JP); ITO, Wataru, Tokyo 100-8071 (JP)
(74) Representative: Vossius & Partner Patentanwälte Rechtsanwälte mbB
(86) International application number: PCT/JP2012/060751
(87) International publication number: WO 2012/144614

(56) References cited:
- WO-A1-2008/011022
- JP-A- 2006 028 016
- JP-A- 2006 321 696
- JP-A- 2009 256 138
- JP-A- 2009 544 171
- JP-A- 2011 121 847
- LA VIA F ET AL: "4H-SiC epitaxial layer growth by trichlorosilane (TCS)", JOURNAL OF CRYSTAL GROWTH, ELSEVIER, AMSTERDAM, NL, vol. 311, no. 1, 15 December 2008 (2008-12-15), pages 107-113, XP025816565, ISSN: 0022-0248, DOI: 10.1016/J.JCRYSGRO.2008.10.041 [retrieved on 2008-10-21]
- LEONE S ET AL: "Growth of smooth 4H-SiC epilayers on 4 off-axis substrates with chloride-based CVD at very high growth rate", MATERIALS RESEARCH BULLETIN, ELSEVIER, KIDLINGTON, GB, vol. 46, no. 8, 29 March 2011 (2011-03-29) , pages 1272-1275, XP028225710, ISSN: 0025-5408, DOI: 10.1016/J.MATERRESBULL.2011.03.029 [retrieved on 2011-04-05]
- GANG JI ET AL: "High epitaxial growth rate of 4H-SiC using TCS as silicon precursor", SOLID-STATE AND INTEGRATED-CIRCUIT TECHNOLOGY, 2008. ICSICT 2008. 9TH INTERNATIONAL CONFERENCE ON, IEEE, PISCATAWAY, NJ, USA, 20 October 2008 (2008-10-20), pages 696-698, XP031384368, DOI: 10.1109/ICSICT.2008.4734649 ISBN: 978-1-4244-2185-5
- KOTAMRAJU S ET AL: "Low-temperature homoepitaxial growth of 4H-SiC with CH3Cl and SiCl4 precursors", JOURNAL OF CRYSTAL GROWTH, ELSEVIER, AMSTERDAM, NL, vol. 312, no. 5, 15 February 2010 (2010-02-15), pages 645-650, XP026873599, ISSN: 0022-0248 [retrieved on 2010-01-25]
- F. LA VIA ET AL.: '4H-SiC epitaxial layer growth by trichlorosilane (TCS)' JOURNAL OF CRYSTAL GROWTH vol. 311, 2008, pages 107 - 113

## Description

### TECHNICAL FIELD

The present invention relates to a method for producing an epitaxial silicon carbide (SiC) single crystal substrate.

### BACKGROUND ART

Silicon carbide (SiC), which is excellent in heat resistance and mechanical strength, and physically and chemically stable, is being spotlighted as an environmentally resistant semiconductor material. In addition, in recent years there has been an increased demand for a SiC single crystal substrate as a substrate for high-frequency and high-voltage electronic devices and the like.

For the production of an electronic device, a high frequency device, or the like using a SiC single crystal substrate, it is common to carry out epitaxial growth of an SiC thin film on a substrate using a method referred to as a thermal CVD method (a thermal chemical vapor deposition method) or directly implant a dopant therein by an ion implantation method. However, the latter needs annealing at high temperature after implantation. Accordingly, epitaxial growth is more frequently used to form a thin film.

Currently, predominant diameters of SiC substrates are 3 and 4-inches (76 mm and 100 mm), and thus, epitaxial growth is carried out on such a substrate. From the viewpoints such as reduction in the density of defects such as basal plane dislocations and increase in the yield of substrates cut from a SiC ingot, the off-angle of a substrate used is from 8° as a conventional angle to about 4° or less.

In the case of an epitaxial layer on a substrate having an off-angle of 4°, among basal plane dislocations in the substrate, those that are not converted to edge dislocations at an interface between the substrate and the epitaxial layer and taken over as they are by the epitaxial layer are present at a density of about 100 to 200/cm². Some of the basal plane locations are known to be dissociated into two partial dislocations in a SiC crystal and have a stacking fault therebetween (Non-Patent literature 1). When the stacking fault is present inside a device, the stacking fault is shown to have negative influence on the reliability of a bipolar device, a Shottky barrier diode, or the like (Non-Patent literature 2). When the size of a device is larger, even in the case of basal plane dislocations having the density of the above level, stacking faults caused by the dislocations are more likely to be present inside the device, thus resulting in reducing the characteristics and yield of the device.

However, the stacking faults do not have morphological characteristics, unlike defects such as triangular defects, carrots, and comets usually observed on a SiC epitaxial layer, and therefore cannot be recognized by microscopic observation. Accordingly, other observation techniques are needed. Currently, a photoluminescence method (PL method) is most frequently used. The PL method specifies the kind and location of a defect by irradiating a sample with light having an energy not less than a band gap of the sample to excite an electron and then observing light emission occurring when the excited electron drops to an energy level formed by the defect in the band gap. In the case of SiC, light emission wavelengths from energy levels formed by stacking faults are present in large numbers in a range of 400 to 600 nm. In particular, regarding energy levels having light emission wavelengths near 420 nm, 460 nm, 480 nm, and 500 nm, research has been made on the structure of stacking faults inducing the energy levels and the origin of the stacking faults (Non-Patent Literature 3). According to the Literature, stacking faults emitting light at 420 nm are single Shockley-type stacking faults or 3C type stacking faults; stacking faults emitting light at 460 nm are quadruple Shockley-type stacking faults; stacking faults emitting light at 480 nm are triple Shockley-type stacking faults; and stacking faults emitting light at 500 nm are double Shockley-type stacking faults. Among them, an example of stacking faults emitting light at a wavelength near 460 nm is depicted in FIG. 1 (cited from Non-Patent Literature 4).

However, the relationship among the conditions of epitaxial growth and the kind, density, and the like of stacking faults has not been sufficiently clarified. In the case of an epitaxial layer on an ordinary substrate having the off-angle of 4°, the number of stacking faults emitting light at wavelengths ranging from 400 to 600 nm observed by the PL method is 10/cm² or more in total.

Accordingly, although the SiC epitaxial growth substrate is expected to be applied to devices in the future, stacking faults are currently present at a density of 10/cm² or more even when the off-angle of the substrate is set to 4° or less to reduce basal plane dislocations in an epitaxial layer so that stacking faults caused thereby are reduced. This means that when the electrode area of a device is about 3 mm square, the number of stacking faults included therein is one or more, deteriorating the characteristics and reliability of the device. In order to reduce the number of stacking faults present under the electrode to less than one, a stacking fault density of less than 10/cm² is needed. However, as described above, since stacking faults cannot be observed by microscopy and the relationship among epitaxial growth conditions and the kind, density, and the like of stacking faults have yet to be sufficiently clarified. Therefore, it has been difficult to stably form an epitaxial film having low stacking fault density.

### CITATION LIST

### Non-Patent Literature

Non-Patent Literature 1: X. J. Ning et al.: Journal of American Ceramics Soc. Vol. 80 (1997) p.1645.
Non-Patent Literature 2: H. Fujiwara et al.: Applied Physics Letters Vol.87 (2005) 051912.
Non-Patent Literature 3: G. Feng et al.. Physica B 404 (2009) p4745.
Non-Patent Literature 4: R. Hattori et al: Materials Science Forum Vols. 615-617 (2009) p 129.

The article "4H-SiC epitaxial layer growth by trichlorosilane (TCS)" by F. La Via et al., published in the Journal of Crystal Growth 311 (2008), pages 107-113, discloses epitaxial growth on 4H-SiC substrates using trichlorosilane and ethylene as source gases. It does not disclose a growth rate of 1-3 micrometer per hour in combination with growth conditions as defined in claim 1. Furthermore it does not disclose the use of a substrate having a diameter of 4 inches or more.

### SUMMARY OF THE INVENTION

### PROBLEM TO BE SOLVED BY THE INVENTION

It is an object of the present invention to provide a method for producing an epitaxial SiC single crystal substrate that has a high quality epitaxial film with low stacking fault density in epitaxial growth using a substrate having an off-angle of 4° or less.

### MEANS FOR SOLVING THE PROBLEM

The present invention found that the aforementioned problems can be solved by performing epitaxial growth by using chlorosilane as a silicon-based material gas and controlling a ratio of the number of carbon atoms in a carbon-based material gas to the number of silicon atoms in the silicon-based material gas (C/Si ratio), growth temperature, and growth rate during the epitaxial growth, thereby leading to the completion of the invention.

Specifically, the present invention provides the following:
A method for producing an epitaxial silicon carbide single crystal substrate as defined in claim 1.

### ADVANTAGES OF THE INVENTION

The present invention can provide a method for producing a SiC single crystal substrate having a high quality epitaxial film with low stacking fault density in an epitaxial film on a substrate having an off-angle of 4° or less.

In addition, since the production method of the present invention is the CVD method, apparatus configuration is easy and controllability is excellent, thereby allowing the production of an epitaxial film with high evenness and high reproducibility. In particular, the production method of the invention can achieve a stable step-flow growth even in a substrate having a diameter of 4 inches or more.

Furthermore, when a device using the epitaxial SiC single crystal substrate grown according to the method of the present invention is formed on a high-quality epitaxial film having low stacking fault density, the characteristics, reliability and yield of the device are improved.

### BRIEF DESCRIPTION OF THE DRAWINGS

FIG. 1 is an example of stacking faults emitting light at a wavelength near 460 nm by a PL method.
FIG. 2 is a view depicting a typical growth sequence used when performing a conventional epitaxial growth.
FIG. 3 is a view depicting a growth sequence used when performing epitaxial growth by one method of the present invention.
FIG. 4 is an optical micrograph depicting a surface state of a film on which epitaxial growth has been carried out by one method of the present invention.

### MODES FOR CARRYING OUT THE INVENTION

A detailed description of the present invention will be given below.

First, a description will be given of epitaxial growth on a SiC single crystal substrate.

A suitable apparatus used for the epitaxial growth in the present invention is a horizontal CVD apparatus. CVD method, in which apparatus configuration is simple and growth control can be done by the on/off condition of gas supply, is a growth method excellent in controllability and reproducibility of an epitaxial film. In addition, other than the CVD method, a molecular beam epitaxy method (MBE method), a liquid layer epitaxy method (LPE method), or the like can be used to perform epitaxial growth.

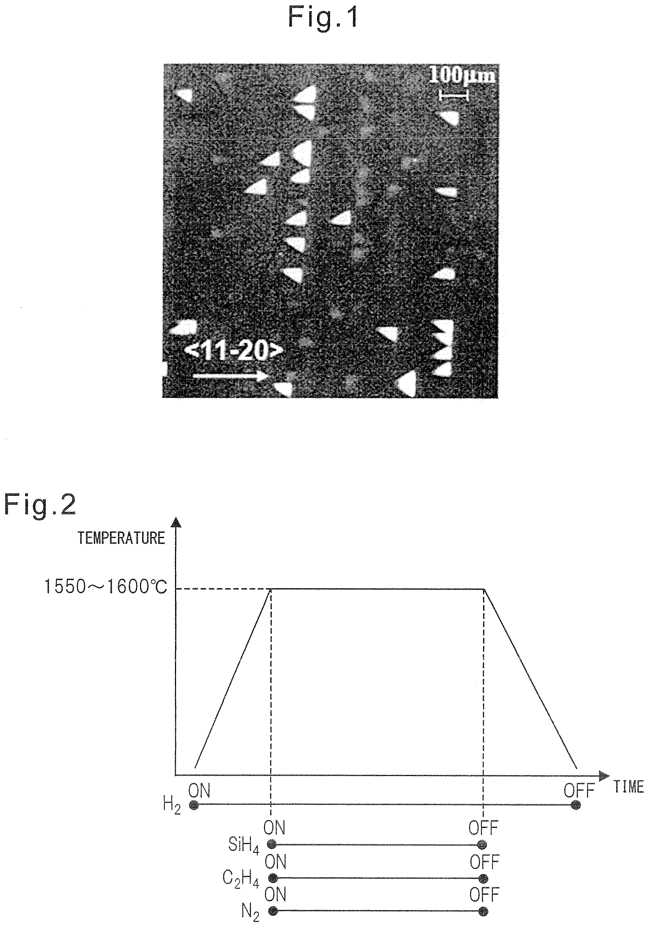

FIG. 2 depicts a growth sequence used in a typical CVD method when performing a conventional epitaxial film growth, in combination with gas introduction timings. First, a substrate is placed in a growth furnace and the inside of the growth furnace is evacuated. Then, hydrogen gas is introduced to adjust the pressure to 1×10⁴ to 3×10⁴ Pa. Next, the temperature of the growth furnace is increased while maintaining the pressure constant. After reaching a growth temperature of 1550 to 1600°C, SiH₄ and C₂H₄ as material gasses and N₂ as a doping gas are introduced to start growth. SiH₄ has a flow rate of 40 to 50 cm³/min and C₂H₄ has a flow rate of 20 to 40 cm³/min; and the rate of growth is 6 to 7 µm/hr. The growth rate has been determined in consideration of productivity since an ordinarily used epitaxial layer has a film thickness of about 10 µm. At a point in time where a desired film thickness has been obtained after performing the growth for a predetermined time, the introduction of SiH₄, C₂H₄, and N₂ is stopped and the temperature is lowered in a state in which only hydrogen gas is flowing. After the temperature is lowered to room temperature, the introduction of hydrogen gas is stopped. Next, the inside of the growth chamber is evacuated; then, inert gas is introduced into the growth chamber to return the pressure of the growth chamber to an atmospheric pressure; and the substrate is taken out from the chamber.

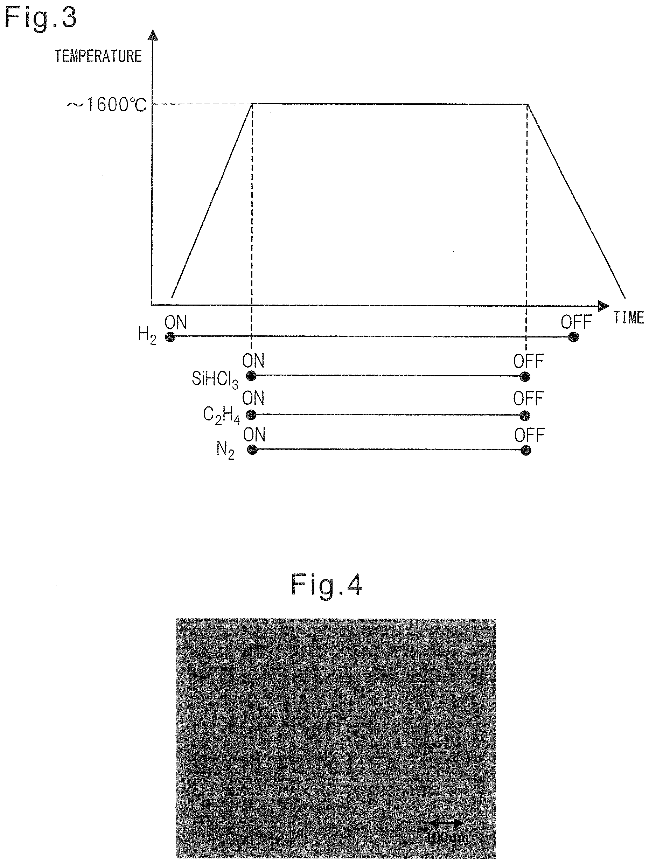

Next, the present invention will be described using an example of a growth sequence in a CVD method depicted in FIG. 3. After placing a SiC single crystal substrate in a growth furnace and evacuating the inside of the growth furnace, hydrogen gas is introduced to adjust the pressure inside the furnace to 1×10⁴ to 3×10⁴ Pa. Then, the temperature of the growth furnace is increased while maintaining the pressure constant. When the temperature reaches about 1600°C, chlorosilane gas (trichlorosilane in FIG. 3) and C₂H₄ as material gasses and N₂ as a doping gas are introduced to start growth. The subsequent steps are the same as those in FIG. 2. In this way, by using chlorosilane as a silicon-based material gas, stacking fault density is reduced as compared to the use of the silane gas in the conventional art. The reason for this seems to be as follows.

A stacking fault occurs due to the dissociation of a basal plane dislocation taken over to an epitaxial layer from a substrate into two partial dislocations, which means the occurrence of disorder in the epitaxial growth. Silane gas is decomposed into a compound having a form of SiₓH_{y}, which is decomposed on a terrace of a growth surface and then Si atoms are incorporated into steps or kinks to be grown. When there is any surface defect or minute unevenness, the Si atoms aggregate at the site, disturbing the step-flow growth. However, chlorosilane gas represented by SiHₘClₙ (m + n = 4; m is an integer of 0 to 3; and n is an integer of 1 to 4) is decomposed into a stable form of SiCl₂ in gas phase and, in that state, supplied to steps or kinks. Thus, the chlorosilane gas is not easily influenced by any surface defect and minute unevenness, thereby allowing a stable step-flow growth. As a result, stacking faults can be reduced. As used herein, the term "stacking faults" means those emitting light at wavelengths ranging from 400 to 600 nm by the PL method and refers to Shockley-type stacking faults or 3C type stacking faults, which generally do not have morphological characteristics. These stacking faults cannot be recognized by surface observation through a conventional microscope. However, using a substrate having such stacking faults in a device reduces the characteristics and yield of the device. An example of a yield evaluation method is as follows: Shottky barrier diodes are formed and then a forward voltage is applied thereto to compare n values of the diodes. An ideal n value is 1.0. The n value becomes larger along with the deterioration of the characteristics. The yield can be evaluated by obtaining a conforming product rate using Shottky barrier diodes having n values of 1.10 or less as conforming products.

The present invention can produce a favorable epitaxial film having low stacking fault density in an epitaxial film on a substrate having an off-angle of 4° or less. However, since the off-angle is relatively small, growth temperature needs to be high to some extent and C/Si ratio needs to be small to facilitate the occurrence of step-flow growth. The inventors conducted examinations in consideration of the circumstances as above and consequently found that the growth temperature is 1600°C or more. However, temperatures that are too high cause surface roughness. Accordingly, a temperature of 1700°C or less is used. More suitably, the growth temperature is 1620 to 1680°C. In addition, when the C/Si ratio is too low, the incorporation of residual nitrogen increases, whereas when the ratio is too high, the effect of facilitating step-flow growth is reduced. Accordingly, the C/Si ratio is 0.5 to 1.0, and more suitably 0.6 to 0.8.

Furthermore, too low growth rates cause a problem of productivity, whereas too high growth rates easily cause disorders in growth. Accordingly, the growth rate is 1 to 3 µm/hr, and more suitably 1.5 to 2.5 µm/hr. Additionally, in order to supply a material gas in the form of SiCl₂ obtained by decomposition, gasses having a larger ratio of Cl to Si among chlorosilanes are more advantageous. Thus, trichlorosilane and tetrachlorosilane are preferable. Additionally, as carbon-based raw material gas, hydrocarbon gases such as unsaturated hydrocarbons and saturated hydrocarbons may be used. Of these gasses, an example of the former is ethylene and examples of the latter are ethane and propane, although not limited thereto.

The silicon carbide substrate used for the epitaxial silicon carbide single crystal substrate of the present invention has an off-angle of 4° or less. However, this is due to demands including reduction in number of defects, such as basal plane dislocations and an increase in the yield of substrates cut from an ingot.

Additionally, the diameter of the substrate is 4 inches or more. This seems to be due to the following reason. As the substrate diameter becomes larger, Si species supplied on the substrate need to move over a long distance on the surface in order to be incorporated in steps or kinks. However, in that case, the advantage of the present invention supplying Si species in the stable form of SiCl₂ is further executed.

More specifically, in general, a larger substrate diameter causes unevenness in the substrate temperature and also increases a distance over which the supplied Si species move to be incorporated into steps or kinks. Such an environment makes step-flow growth unstable.

As described above, the silane gas decomposed becomes a compound having the form of SiₓH_{y}, which is decomposed on the terrace of a growth surface and Si atoms are incorporated in steps or kinks to be grown. However, the presence of any surface defect or minute roughness causes the aggregation of the Si atoms at the site, resulting in disturbance to step-flow growth.

The problem not apparent on a 2- or 3-inch substrate because of relatively small levels of temperature unevenness and movement distance of the Si species can become apparent on a substrate having a diameter of 4 inches or more. In other words, the probability of disturbing step-flow growth increases.

However, the chlorosilane gas is decomposed into a stable form of SiCl₂ in the gas phase and, in that state, supplied into steps or kinks. Accordingly, the chlorosilane is hardly influenced by any surface defect and minute roughness and thus a stable step-flow growth is achieved. As a result, stacking faults can be reduced. In particular, even in the case of a large substrate having a diameter of 4 inches or more, stacking faults can consequently be reduced.

Furthermore, the necessity to reduce the number of stacking faults observed by the PL method to less than 10/cm² results from the following reason. Current devices have an electrode area of about 3 mm square, and reducing the number of stacking faults included in the electrode to one or less improves the characteristics and reliability of the devices. In particular, stacking faults emitting light at 460 nm occur in an unstable epitaxial growth and have great influence on a device, so that the number of stacking faults needs to be less than 5/cm². The number of stacking faults emitting light at other wavelengths needs to satisfy, first, the number of less than 5/cm² as above and, in total, less than 10/cm². Additionally, in the future, the electrode area of devices is expected to be about 5 mm square.

Accordingly, even in that case, the number of stacking faults observed by the PL method is more preferably 4/cm² or less so that the number of stacking faults included in the electrode is one or less. When a Shottky barrier diode is formed using a substrate having stacking faults of less than 10/cm², the conforming product rate, namely, the yield exceeds about 70%. In the present invention, the number of stacking faults on the epitaxial layer is detected by measurement using the PL method, as described in Examples below.

Examples of a device suitably formed on the epitaxial SiC single crystal substrate thus obtained include a Shottky barrier diode, a PIN diode, a MOS diode, and a MOS transistor. Above all, particularly suitable ones are devices used to control electric power.

### EXAMPLES

Hereinafter, the present invention will be described in more detail with reference to Examples. However, the present invention is not limited to the following contents.

Examples 1-6 and 8 use 3-inch or 2-inch diameter substrates respectively and are thus outside the scope of the invention as defined in claim 1.

### (Example 1)

A SiC single crystal ingot for a 3-inch (76 mm) wafer was sliced to a thickness of about 400 µm. Then, rough scraping and ordinary polishing with diamond abrasive grains were carried out to form a 4H polytype SiC single crystal substrate. Next, epitaxial growth was carried out on a Si surface of the SiC single crystal substrate. The substrate had an off-angle of 4°. Epitaxial growth steps are as follows. The substrate was placed in a growth furnace and the inside of the growth furnace was evacuated. Then, the inner pressure was adjusted to 1.0×10⁴ Pa while introducing hydrogen gas at 150 L/min. After that, the temperature of the growth furnace was increased to 1600°C while maintaining the pressure constant, and an epitaxial layer was grown to a thickness of about 10 µm by introducing trichlorosilane (SiHCl₃) at a flow rate of 20 cm³/min, C₂H₄ at a flow rate of 8 cm³/min (C/Si ratio: 0.8), and also N₂ as a doping gas at a flow rate of 1 cm³/min. The growth rate at that time was 2.5 µm/hr.

The epitaxially grown film thus obtained was evaluated by the PL method. As a light source, a mercury-based UV light source (wavelength: 313 nm) was used in such a manner that UV light was applied onto an entire region of the epitaxial layer. In the case of SiC, among light emission wavelengths from energy levels induced by stacking faults, those present in the range of 400 to 600 nm are about 420 nm, about 460 nm, about 480 nm, and about 500 nm. Thus, regarding the obtained photoluminescence light, detection through a band pass filter for the four wavelengths was carried out by a CCD detector to measure the number of stacking faults emitting light at each of the wavelengths, with the result that the number of stacking faults was 8/cm² in total. This indicated the formation of a good quality film having low stacking fault density. More specifically, the numbers of faults at 420 nm, 460 nm, 480 nm, and 500 nm, respectively, were 4/cm², 2/cm², 1/cm², and 1/cm², respectively. The CCD detector used herein had one million pixels (element size: 13 µm × 13 µm) and was a deep depletion type. Accordingly, the CCD detector had high sensitivity in a range of from a SiC band end emission wavelength to a near-infrared region. Light emissions detected by the CCD detector were counted as stacking faults. In addition, FIG. 4 depicts an optical micrograph of an epitaxial film surface, indicating that the film obtained is a high quality film having less surface defects.

Furthermore, on the epitaxial film (the epitaxial layer) was formed a Shottky barrier diode having a 3 mm square electrode, and additionally, also on an epitaxial film of Comparative Example 1 described below was formed a Shottky barrier diode having the same size. Then, a forward voltage was applied to each of the diodes to compare n values of the diodes. An ideal n value is 1.0 and, along with the deterioration of the characteristics, the n value becomes larger. When a Shottky barrier diode having an n value of 1.10 or less was regarded as a high quality product, the Shottky barrier diode of Example 1 has a conforming product rate of 75%, whereas the Shottky barrier diode of Comparative Example 1 had a conforming product rate of 60%. Thus, the yield of the Shottky barrier diode of Example 1 was higher.

### (Example 2)

Slicing, rough scraping, and ordinary polishing were carried out in the same manner as Example 1 to obtain a 3-inch (76 mm) SiC single crystal substrate having a 4H polytype, and epitaxial growth was carried out on an Si surface of the SiC single crystal substrate. The substrate had an off-angle of 4°. The steps before starting the growth, the temperature, and the like were the same as those in Example 1. Then, an epitaxial layer was grown to a thickness of about 10 µm by introducing tetrachlorosilane (SiCl₄) at a flow rate of 20 cm³/min, C₂H₄ at a flow rate of 6 cm³/min (C/Si ratio: 0.6), and also N₂ as a doping gas at a flow rate of 1 cm³/min. The growth rate at that time was 2.5 µm/hr. The epitaxially grown film thus obtained was evaluated by the PL method in the same manner as Example 1 to measure the number of stacking faults emitting light at wavelengths ranging from 400 to 600 nm, with the result that the number of stacking faults was 8/cm² in total. The obtained film was found to be a good quality film having low stacking fault density and less surface defects. More specifically, the numbers of faults at 420 nm, 460 nm, 480 nm, and 500 nm, respectively, were 3/cm², 3/cm², 1/cm², and 1/cm², respectively. In addition, as with Example 1, a Shottky barrier diode was formed on the film to obtain a conforming product rate of the diode, resulting in 75%.

### (Example 3)

Slicing, rough scraping, and ordinary polishing were carried out in the same manner as Example 1 to obtain a 3-inch (76 mm) SiC single crystal substrate having a 4H polytype, and epitaxial growth was carried out on an Si surface of the SiC single crystal substrate. The substrate had an off-angle of 2°. The steps before starting the growth, the temperature, and the like were the same as those in Example 1. Then, an epitaxial layer was grown to a thickness of about 10 µm by introducing trichlorosilane (SiHCl₃) at a flow rate of 30 cm³/min, C₂H₄ at a flow rate of 15 cm³/min (C/Si ratio: 1.0), and also N₂ as a doping gas at a flow rate of 1 cm³/min. The growth rate at that time was 3 µm/hr. The epitaxially grown film thus obtained was evaluated by the PL method in the same manner as Example 1 to measure the numbers of stacking faults emitting light at wavelengths ranging from 400 to 600 nm, with the result that the number of the stacking faults was 6/cm² in total. The obtained film was found to be a good quality film having low stacking fault density and less surface defects. More specifically, the numbers of faults at 420 nm, 460 nm, 480 nm, and 500 nm, respectively, were 2/cm², 2/cm², 1/cm², and 1/cm², respectively. Additionally, as with Example 1, a Shottky barrier diode was formed on the film to obtain a conforming product rate of the diode, resulting in 78%.

### (Example 4)

As with Example 1, slicing, rough scraping, and ordinary polishing were carried out to obtain a 3-inch (76 mm) SiC single crystal substrate having a 4H polytype, and epitaxial growth was carried out on an Si surface of the SiC single crystal substrate. The substrate had an off-angle of 2°. The steps before starting the growth were the same as those in Example 1, but the growth temperature was set to 1625°C. Then, an epitaxial layer was grown to a thickness of about 10 µm by introducing trichlorosilane (SiHCl₃) at a flow rate of 20 cm³/min, C₂H₄ at a flow rate of 8 cm³/min (C/Si ratio: 0.8), and also N₂ as a doping gas at a flow rate of 1 cm³/min. The growth rate at that time was 2.5 µm/hr. The epitaxially grown film thus obtained was evaluated by the PL method in the same manner as Example 1 to measure the numbers of stacking faults emitting light at wavelengths ranging from 400 to 600 nm, with the result that the number of stacking faults was 4/cm² in total. The obtained film was found to be a good quality film having low stacking fault density and less surface defects.

More specifically, the numbers of faults at 420 nm, 460 nm, 480 nm, and 500 nm, respectively, were 1/cm², 2/cm², 1/cm², and 0/cm², respectively. Additionally, as with Example 1, a Shottky barrier diode was formed on the film to obtain a conforming product rate of the diode, resulting in 80%.

### (Example 5)

Slicing, rough scraping, and ordinary polishing were carried out in the same manner as Example 1 to obtain a 3-inch (76 mm) SiC single crystal substrate having a 4H-polytype, and epitaxial growth was carried out on an Si surface of the SiC single crystal substrate. The substrate had an off-angle of 0.5°. The steps before starting the growth, the temperature, and the like were the same as those in Example 1. Then, an epitaxial layer was grown to a thickness of about 10 µm by introducing trichlorosilane (SiHCl₃) at a flow rate of 30 cm³/min, C₂H₄ at a flow rate of 7.5 cm³/min (C/Si ratio: 0.5), and also N₂ as a doping gas at a flow rate of 1 cm³/min. The growth rate at that time was 2 µm/hr. The epitaxially grown film thus obtained was evaluated by the PL method in the same manner as Example 1 to measure the numbers of stacking faults emitting light at wavelengths ranging from 400 to 600 nm, with the result that the number of stacking faults was 4/cm² in total. The obtained film was found to be a good quality film having low stacking fault density and less surface defects. More specifically, the numbers of faults at 420 nm, 460 nm, 480 nm, and 500 nm, respectively, were 2/cm², 2/cm², 0/cm², and 0/cm², respectively. Additionally, as with Example 1, a Shottky barrier diode was formed on the film to obtain a conforming product rate of the diode, resulting in 80%.

### (Example 6)

Slicing, rough scraping, and ordinary polishing were carried out in the same manner as Example 1 to obtain a 3-inch (76 mm) SiC single crystal substrate having a 4H polytype, and epitaxial growth was carried out on an Si surface of the SiC single crystal substrate. The substrate had an off-angle of 4°. The steps before starting the growth were the same as those in Example 1, but the growth temperature was set to 1650°C. Then, an epitaxial layer was grown to a thickness of about 10 µm by introducing trichlorosilane (SiHCl₃) at a flow rate of 20 cm³/min, C₂H₄ at a flow rate of 8 cm³/min (C/Si ratio: 0.8), and also N₂ as a doping gas at a flow rate of 1 cm³/min. The growth rate at that time was 2.5 µm/hr. The epitaxially grown film thus obtained was evaluated by the PL method in the same manner as Example 1 to measure the numbers of stacking faults emitting light at wavelengths ranging from 400 to 600 nm, with the result that the number of stacking faults was 6/cm² in total. The obtained film was found to be a good quality film having low stacking fault density and less surface defects.
More specifically, the numbers of faults at 420 nm, 460 nm, 480 nm, and 500 nm, respectively, were 2/cm², 2/cm², 1/cm² , and 1/cm², respectively. Additionally, as with Example 1, a Shottky barrier diode was formed on the film to obtain a conforming product rate of the diode, resulting in 77%.

### (Example 7)

Slicing, rough scraping, and ordinary polishing were carried out in the same manner as Example 1 to obtain a 4-inch (100 mm) SiC single crystal substrate having a 4H polytype, and epitaxial growth was carried out on an Si surface of the SiC single crystal substrate. The substrate had an off-angle of 4°. The steps before starting the growth, the temperature, and the like were the same as those in Example 1. Then, an epitaxial layer was grown to a thickness of about 10 µm by introducing tetrachlorosilane (SiCl₄) at a flow rate of 20 cm³/min, C₂H₄ at a flow rate of 6 cm³/min (C/Si ratio: 0.6), and also N₂ as a doping gas at a flow rate of 1 cm³/min. The growth rate at that time was 2.5 µm/hr. The epitaxially grown film thus obtained was evaluated by the PL method to measure the numbers of stacking faults emitting light at wavelengths ranging from 400 to 600 nm, with the result that the number of stacking faults was 9/cm² in total. The obtained film was found to be a good quality film having low stacking fault density and less surface defects. More specifically, the numbers of faults at 420 nm, 460 nm, 480 nm, and 500 nm, respectively, were 3/cm², 3/cm², 2/cm², and 1/cm², respectively. In addition, as with Example 1, a Shottky barrier diode was formed on the film to obtain a conforming product rate of the diode, resulting in 79%.

### (Example 8)

Slicing, rough scraping, and ordinary polishing were carried out in the same manner as Example 1 to obtain a 2-inch (50 mm) SiC single crystal substrate having a 4H polytype, and epitaxial growth was carried out on an Si surface of the SiC single crystal substrate. The substrate had an off-angle of 4°. The steps before starting the growth, the temperature, and the like were the same as those in Example 1. Then, an epitaxial layer was grown to a thickness of about 10 µm by introducing tetrachlorosilane (SiCl₄) at a flow rate of 20 cm³/min, C₂H₄ at a flow rate of 8 cm³/min (C/Si ratio: 0.8), and also N₂ as a doping gas at a flow rate of 1 cm³/min. The growth rate at that time was 2.7 µm/hr. The epitaxially grown film thus obtained was evaluated by the PL method to measure the numbers of stacking faults emitting light at wavelengths ranging from 400 to 600 nm, with the result that the number of stacking faults was 5/cm² in total. Thus, the obtained film was found to be a good quality film having low stacking fault density and less surface defects. More specifically, the numbers of faults at 420 nm, 460 nm, 480 nm, and 500 nm, respectively, were 1/cm², 2/cm², 1/cm², and 1/cm², respectively. In addition, as with Example 1, a Shottky barrier diode was formed on the film to obtain a conforming product rate of the diode, resulting in 82%.

### (Comparative Example 1)

As with Example 1, slicing, rough scraping, and ordinary polishing were carried out to obtain a 3-inch (76 mm) SiC single crystal substrate having a 4H polytype, and epitaxial growth was carried out on an Si surface of the SiC single crystal substrate. The substrate had an off-angle of 4°. The steps before starting the growth, the temperature, and the like were the same as those in Example 1, but silane (SiH₄) was used as a silicon-based material gas. Then, an epitaxial layer was grown to a thickness of about 10 µm by introducing SiH₄ at a flow rate of 40 cm³/min, C₂H₄ at a flow rate of 22 cm³/min (C/Si ratio: 1.1), and also N₂ as a doping gas at a flow rate of 1 cm³/min. The growth rate at that time was 6 µm/hr. The epitaxially grown film thus obtained was evaluated by the PL method in the same manner as Example 1 to measure the numbers of stacking faults emitting light at wavelengths ranging from 400 to 600 nm, with the result that the number of the stacking faults in total was 20/cm², which was a high stacking fault density. More specifically, the numbers of faults at 420 nm, 460 nm, 480 nm, and 500 nm, respectively, were 7/cm², 8/cm², 3/cm², and 2/cm², respectively. In addition, as described in Example 1, a conforming product rate of a Shottky barrier diode formed on the epitaxial film was calculated, resulting in 60%.

### (Comparative Example 2)

As with Example 1, slicing, rough scraping, and ordinary polishing were carried out to obtain a 3-inch (76 mm) SiC single crystal substrate having a 4H polytype, and epitaxial growth was carried out on an Si surface of the SiC single crystal substrate. The substrate had an off-angle of 4°. The steps before starting the growth were the same as those in Example 1, but the growth temperature was set to 1550°C. Then, an epitaxial layer was grown to a thickness of about 10 µm by introducing trichlorosilane (SiHCl₃) at a flow rate of 30 cm³/min, C₂H₄ at a flow rate of 12 cm³/min (C/Si ratio: 0.8), and also N₂ as a doping gas at a flow rate of 1 cm³/min. The growth rate at that time was 2 µm/hr. The epitaxially grown film thus obtained was evaluated by the PL method in the same manner as Example 1 to measure the numbers of stacking faults emitting light at wavelengths ranging from 400 to 600 nm, with the result that the number of the stacking faults in total was 18/cm², which was a high stacking fault density. More specifically, the numbers of faults at 420 nm, 460 nm, 480 nm, and 500 nm, respectively, were 7/cm², 7/cm², 2/cm², and 2/cm², respectively. In addition, as with Example 1, a Shottky barrier diode was formed on the epitaxial film to measure a conforming product rate of the diode, resulting in 60%.

### (Comparative Example 3)

As with Example 1, slicing, rough scraping, and ordinary polishing were carried out to obtain a 3-inch (76 mm) SiC single crystal substrate having a 4H polytype, and epitaxial growth was carried out on an Si surface of the SiC single crystal substrate. The substrate had an off-angle of 4°. The steps before starting the growth, the growth temperature, and the like were the same as those in Example 1. Then, an epitaxial layer was grown to a thickness of about 10 µm by introducing trichlorosilane (SiHCl₃) at a flow rate of 30 cm³/min, C₂H₄ at a flow rate of 22.5 cm³/min (C/Si ratio: 1.5), and also N₂ as a doping gas at a flow rate of 1 cm³/min. The growth rate at that time was 3 µm/hr. The epitaxially grown film thus obtained was evaluated by the PL method in the same manner as Example 1 to measure the numbers of stacking faults emitting light at wavelengths ranging from 400 to 600 nm, with the result that the number of the stacking faults in total was 15/cm², which was a high stacking fault density. More specifically, the numbers of faults at 420 nm, 460 nm, 480 nm, and 500 nm, respectively, were 4/cm², 6/cm², 3/cm², and 2/cm², respectively. In addition, as with Example 1, a Shottky barrier diode was formed on the epitaxial film to measure a conforming product rate of the diode, resulting in 65%.

### (Comparative Example 4)

As with Example 1, slicing, rough scraping, and ordinary polishing were carried out to obtain a 4-inch (100 mm) SiC single crystal substrate having a 4H polytype, and epitaxial growth was carried out on an Si surface of the SiC single crystal substrate. The substrate had an off-angle of 4°. The steps before starting the growth, the temperature, and the like were the same as those in Example 1, but silane (SiH₄) was used as a silicon-based material gas. Then, an epitaxial layer was grown to a thickness of about 10 µm by introducing SiH₄ at a flow rate of 40 cm³/min, C₂H₄ at a flow rate of 20 cm³/min (C/Si ratio: 1.0), and also N₂ as a doping gas at a flow rate of 1 cm³/min. The growth rate at that time was 5.5 µm/hr. The epitaxially grown film thus obtained was evaluated by the PL method to measure the numbers of stacking faults emitting light at wavelengths ranging from 400 to 600 nm, with the result that the number of the stacking faults in total was 40/cm², which was a high stacking fault density. More specifically, the numbers of faults at 420 nm, 460 nm, 480 nm, and 500 nm, respectively, were 12/cm², 15/cm², 7/cm², and 6/cm², respectively. In addition, as with Example 1, a conforming product rate of a Shottky barrier diode formed on the epitaxial film was measured, resulting in 50%.

### (Comparative Example 5)

As with Example 1, slicing, rough scraping, and ordinary polishing were carried out to obtain a 2-inch (50 mm) SiC single crystal substrate having a 4H polytype, and epitaxial growth was carried out on an Si surface of the SiC single crystal substrate. The substrate had an off-angle of 4°. The steps before starting the growth, the temperature, and the like were the same as those in Example 1, but silane (SiH₄) was used as a silicon-based material gas. Then, an epitaxial layer was grown to a thickness of about 10 µm by introducing SiH₄ at a low rate of 40 cm³/min, C₂H₄ at a flow rate of 20 cm³/min, (C/Si ratio: 1.0), and also N₂ as a doping gas at a flow rate of 1 cm³/min. The growth rate at that time was 5.5 µm/hr. The epitaxially grown film thus obtained was evaluated by the PL method to measure the numbers of stacking faults emitting light at wavelengths ranging from 400 to 600 nm, with the result that the number of the stacking faults in total was 11/cm², which was a high stacking fault density. More specifically, the numbers of faults at 420 nm, 460 nm, 480 nm, and 500 nm, respectively, were 3/cm², 4/cm²,
3/cm², and 1/cm², respectively. In addition, as with Example 1, a conforming product rate of a Shottky barrier diode formed on the epitaxial film was measured, resulting in 68%.

### [Industrial Applicability]

The method of the present invention can produce an epitaxial SiC single crystal substrate having a high quality epitaxial film with low stacking fault density in epitaxial growth on an SiC single crystal substrate. Therefore, formation of an electronic device on such a substrate can improve the characteristics and yield of the device.

## Claims

1. A method for producing an epitaxial silicon carbide single crystal substrate, which is a method for producing an epitaxial silicon carbide single crystal substrate by epitaxially growing silicon carbide on a silicon carbide single crystal substrate having an off-angle of 4° or less, wherein the SiC single crystal substrate has a 4H polytype, wherein when the silicon carbide is epitaxially grown on the silicon carbide single crystal substrate, chlorosilane or tetrachlorosilane (SiHₘClₙ (m + n = 4; m is an integer of 0 to 3; and n is an integer of 1 to 4)) is used as a silicon-based material gas and a hydrocarbon gas is used as a carbon-based material gas; a ratio of the number of carbon atoms in the hydrocarbon gas to the number of silicon atoms in the chlorosilane or tetrachlorosilane(C/Si ratio) in the epitaxial growth is 0.5 to 1.0; and the epitaxial growth is carried out at a temperature of 1600 to 1700°C, wherein the substrate is **characterized in that**, in the epitaxial layer, the number of stacking faults emitting light at wavelengths ranging from 400 to 600 nm by photoluminescence is less than 10/cm² in total,
wherein the silicon carbide single crystal substrate has a diameter of 101.6 mm (4 inches) or more,
and
wherein the epitaxial growth is carried out at a growth rate of 1 to 3 µm/hour.

2. The method for producing an epitaxial silicon carbide single crystal substrate according to claim 1, wherein the epitaxial growth uses a thermal chemical vapor deposition method (CVD method).

3. The method for producing an epitaxial silicon carbide single crystal substrate according to any one of claim 1 or 2, wherein the silicon-based material gas is trichlorosilane (SiHCl₃).

4. The method for producing an epitaxial silicon carbide single crystal substrate according to any one of claim 1 or 2, wherein the silicon-based material gas is tetrachlorosilane (SiCl₄).

## Patentansprüche

1. Ein Verfahren zur Herstellung eines epitaxialen Siliciumcarbideinkristallsubstrats, das ein Verfahren zur Herstellung eines epitaxialen Siliciumcarbideinkristallsubstrats durch epitaxiales Wachsen von Siliciumcarbid auf einem Siliciumcarbideinkristallsubstrat mit einem Off-Winkel von 4° oder weniger ist, wobei das SiC-Einkristallsubstrat einen 4H-Polytyp aufweist, wobei, wenn das Siliciumcarbid epitaxial auf dem Siliciumcarbideinkristallsubstrat wächst, Chlorsilan oder Tetrachlorsilan (SiHₘClₙ (m + n = 4; m ist eine ganze Zahl von 0 bis 3; und n ist eine ganze Zahl von 1 bis 4)) als ein Materialgas auf Siliciumbasis verwendet wird und ein Kohlenwasserstoffgas als ein Materialgas auf Kohlenstoffbasis verwendet wird; ein Verhältnis der Zahl der Kohlenstoffatome im Kohlenwasserstoffgas zur Zahl der Siliciumatome im Chlorsilan oder Tetrachlorsilan (C/Si-Verhältnis) in dem epitaxialen Wachstum 0,5 bis 1,0 beträgt; und das epitaxiale Wachstum bei einer Temperatur von 1600 bis 1700°C durchgeführt wird,
wobei das Substrat **dadurch gekennzeichnet ist, dass** in der epitaxialen Schicht die Zahl von Stapelfehlordnungen, die Licht bei Wellenlängen, die von 400 bis 600 nm reichen, durch Fotolumineszenz emittieren, insgesamt kleiner als 10/cm² ist,
wobei das Siliciumcarbideinkristallsubstrat einen Durchmesser von 101,6 mm (4 Zoll) oder mehr aufweist, und
wobei das epitaxiale Wachstum bei einer Wachstumsrate von 1 bis 3 µm/Stunde durchgeführt wird.

2. Das Verfahren zur Herstellung eines epitaxialen Siliciumcarbideinkristallsubstrats nach Anspruch 1, wobei das epitaxiale Wachstum eine thermische chemische Gasphasenabscheidungsverfahren (CVD-Verfahren) verwendet.

3. Das Verfahren zur Herstellung eines epitaxialen Siliciumcarbideinkristallsubstrats nach einem der Ansprüche 1 oder 2, wobei das Materialgas auf Siliciumbasis Trichlorsilan (SiHCl₃) ist.

4. Das Verfahren zur Herstellung eines epitaxialen Siliciumcarbideinkristallsubstrats nach Anspruch 1 oder 2, wobei das Materialgas auf Siliciumbasis Tetrachlorsilan (SiCl₄) ist.

## Revendications

1. Procédé de production d'un substrat de monocristal de carbure de silicium épitaxial, lequel est un procédé de production d'un substrat de monocristal de carbure de silicium épitaxial par croissance épitaxiale de carbure de silicium sur un substrat de monocristal de carbure de silicium présentant un angle décalé de 4° ou inférieur, dans lequel le substrat de monocristal de SiC présente un polytype 4H, dans lequel lorsque le carbure de silicium a crû épitaxialement sur le substrat de monocristal de carbure de silicium, du chlorosilane ou du tétrachlorosilane (SiHₘClₙ (m + n = 4 ; m est un nombre entier de 0 à 3 ; et n est un nombre entier de 1 à 4)) est utilisé comme un gaz de matière à base de silicium et un gaz hydrocarboné est utilisé comme un gaz de matière à base de carbone ; un rapport du nombre d'atomes de carbone dans le gaz hydrocarboné au nombre d'atomes de silicium dans le chlorosilane ou du tétrachlorosilane (rapport C/Si) dans la croissance épitaxiale est de 0,5 à 1,0 ; et la croissance épitaxiale est réalisée à une température de 1 600 à 1 700 °C,
dans lequel le substrat est **caractérisé en ce que**, dans la couche épitaxiale, le nombre de défauts d'empilement émettant de la lumière aux longueurs d'onde comprises entre 400 et 600 nm par photoluminescence est inférieur à 10/cm² au total,
dans lequel le substrat de monocristal de carbure de silicium présente un diamètre de 101,6 mm (4 pouces) ou supérieur,
et
dans lequel la croissance épitaxiale est réalisée à une vitesse de croissance de 1 à 3 µm/heure.

2. Procédé de production d'un substrat de monocristal de carbure de silicium épitaxial selon la revendication 1, dans lequel la croissance épitaxiale utilise un procédé de dépôt chimique thermique en phase vapeur (procédé CVD).

3. Procédé de production d'un substrat de monocristal de carbure de silicium épitaxial selon l'une quelconque des revendications 1 ou 2, dans lequel le gaz de matière à base de silicium est le trichlorosilane (SiHCl₃).

4. Procédé de production d'un substrat de monocristal de carbure de silicium épitaxial selon l'une quelconque de la revendication 1 ou 2, dans lequel le gaz de matière à base de silicium est le tétrachloro-silane (SiCl₄).
